# EUROPÄISCHE PATENTSCHRIFT

(11) **EP 2 822 372 B1**
(45) Veröffentlichungstag und Bekanntmachung des Hinweises auf die Patenterteilung: **14.09.2016**
(21) Anmeldenummer: 13175312.1
(22) Anmeldetag: 05.07.2013
(51) Int. Cl.: H05K 7/14, H05K 1/14

(54) **Gehäuse zur Aufnahme von elektronischen Steckkarten**
Housing for installing electronic plug-in cards
Boîtier destiné à la réception de cartes enfichables électroniques

(43) Veröffentlichungstag der Anmeldung: 07.01.2015
(73) Patentinhaber: Pentair Technical Solutions GmbH, 75334 Straubenhardt (DE)
(72) Erfinder: Dizel, Sergej, 76199 Karlsruhe (DE); Mann, Dietmar, 75196 Remchingen (DE); Gauges, Dietmar, 75045 Walzbachtal (DE); Müller, Jochen, 75331 Engelsbrand (DE)
(74) Vertreter: Durm & Partner

(56) Entgegenhaltungen:
- US-B1- 7 239 528
- Ray Larsen: "Progress in AdvancedTCA for Instrumentation ATCA Summit 2012", , 19. September 2012 (2012-09-19), XP055092307, Gefunden im Internet: URL:http://www.advancedtcasummit.com/Engli sh/Collaterals/Proceedings/2012/20120919_S A201_Larsen.pdf [gefunden am 2013-12-09]
- Eike Waltz: "ATCA Summit 2011 AdvancedTCA Extensions PICMG 3.7 Mechanical", , 2. November 2011 (2011-11-02), XP055092310, Gefunden im Internet: URL:http://www.advancedtcasummit.com/Engli sh/Collaterals/Proceedings/2011/20111102_S 1-201_Waltz.pdf [gefunden am 2013-12-09]

## Beschreibung

Die Erfindung betrifft ein Gehäuse zur Aufnahme von elektronischen Steckkarten mit einer Front, einer Rückseite, einem vorderen Kartenkorb zum Einbau von Steckkarten von der Front her und einem hinteren Kartenkorb zum Einbau von Steckkarten von der Rückseite her. Das Gehäuse umfasst weiter eine erste vertikale Backplane mit einer Vorderseite und einer Rückseite, wobei die erste Backplane am Ende des vorderen Kartenkorbs so befestigt ist, dass ihre Vorderseite zur Front des Gehäuses weist, sowie eine zweite vertikale Backplane mit einer Vorderseite und einer Rückseite, wobei die zweite Backplane parallel und mit Abstand auf der Rückseite der ersten Backplane so angeordnet ist, dass die Vorderseite der zweiten Backplane zur Rückseite des Gehäuses weist. Abstandshalter verbinden die beiden Backplanes miteinander.

Ein derartiges Gehäuse kommt bei modularen Computersystemen für die Telekommunikationsindustrie zum Einsatz. Gemäß neuer bzw. künftiger Normen für solche modularen Computersysteme, zum Beispiel Advanced TCA Extensions, weist der hintere Kartenkorb die gleiche Größe auf wie der vordere Kartenkorb. Dadurch können Steckkarten gleicher Größe sowohl Im vorderen wie auch im hinteren Kartenkorb untergebracht werden.

Beim Einbau der elektronischen Komponenten wird zuerst die erste vertikale Backplane mit dem Gehäuse verschraubt. Die zweite Backplane wird dann mithilfe von Abstandshaltern auf der Rückseite der ersten Backplane befestigt. Anschließend werden die Steckkarten Im vorderen und hinteren Kartenkorb auf die erste bzw. zweite Backplane aufgesteckt.

Bei der Herstellung der Backplanes unterliegt deren Dicke einer Fertigungstoleranz von ca. ± 10 %. Da zusätzlich auch die Länge der Abstandshalter mit einer gewissen Fertigungstoleranz behaftet Ist, weist der Abstand zwischen den Vorderseiten der beiden aufeinander montierten Backplanes eine entsprechend große Gesamttoleranz auf. Diese Toleranz ist für die meisten Anwendungen nicht akzeptabel.

Infolge der Gesamttoleranz schwankt die Einbaulage der zweiten Backplane Im Gehäuse erheblich. Werden beispielsweise Steckbaugruppen in die zweite Backplane eingesteckt, kann die schwankende Gesamttoleranz im schlimmsten Fall dazu führen, dass Steckkarten der Steckbaugruppen aus dem hinteren Kartenkorb herausragen. Die Frontplatten der Steckbaugruppen schließen dann nicht bündig mit dem hinteren Kartenkorb ab. Dies führt dazu, dass das Gehäuse an seiner Rückseite nicht korrekt geschlossen ist.

Das Dokument "Progress In AdvancedTCA for Instrumentation, ATCA Summit 2012", Ray Larsen, 19. September 2012, beschreibt auf Seite 11 eine Anordnung von zwei Backplanes, wobei die zweite Backplane auf der ersten Backplane mithilfe von Abstandshaltern befestigt ist. Sowohl in die erste wie auch in die zweite Backplane sind jeweils Steckkarten gleicher Größe eingesteckt. Seite 11 zeigt ebenfalls Gehäuse, in die eine solche Anordnung eingebaut werden kann.

Dokument "ATCA Summit 2011, AdvancedTCA Extensions PICMG 3.7 Mechanical", 2. November 2012, Eike Waltz, offenbart auf Seite 10 ein Gehäuse mit zwei Backplanes. Das Gehäuse weist einen vorderen und einen hinteren Kartenkorb auf, wobei beide Kartenkörbe gleichgroß ausgebildet sind.

US 7,239,528 B1 offenbart ein Gehäuse mit einem vorderen Kartenkorb, einem hinteren Kartenkorb und einer Midplane. Die Midplane ist am vorderen Kartenkorb befestigt, der mithilfe von Verbindungsstücken mit dem hinteren Kartenkorb verbunden wird. Die Verbindungsstücke weisen Langlöcher auf, anhand der der hintere Kartenkorb relativ zum vorderen Kartenkorb verschoben werden kann. Schwankungen in der Dicke der Midplane können so durch Justierung des hinteren Kartenkorbs ausgeglichen werden. Somit ist gewährleistet, dass im hinteren Kartenkorb montierte Steckkarten unabhängig von der Dlckentoleranz der Midplane nicht mehr aus dem hinteren Kartenkorb herausragen.

Angesichts der beschriebenen Problematik ist es Aufgabe der vorliegenden Erfindung, ein verbessertes Gehäuse bereitzustellen, bei dem die im hinteren Kartenkorb montierten Steckkarten unabhängig von den Fertigungstoleranzen der einzelnen Backplanes nicht aus dem Kartenkorb herausragen.

Gelöst wird diese Aufgabe durch ein Gehäuse zur Aufnahme von elektronischen Steckkarten mit den Merkmalen des Anspruchs 1.

Erfindungsgemäß sind an mindestens einer der einander zugewandten Rückseiten der beiden parallelen Backplanes Plansenkungen vorgesehen, an deren Grund die Abstandshalter anliegen. Die Tiefen der Plansenkungen sind erfindungsgemäß derart gewählt, dass der Abstand zwischen der Vorderseite der zweiten Backplane und der Front des Gehäuses einem vorbestimmten Wert entspricht. Dabei wird die Front des Gehäuses von den Teil-Frontplatten der Steckbaugruppen gebildet, deren Steckkarten auf die erste Backplane aufgesteckt werden. Es ist gleichbedeutend, die Tiefen der Plansenkungen so zu wählen, dass der Abstand zwischen der Vorderseite der zweiten Backplane und einer Anschlagfläche, an der die Fronplatten am vorderen Kartenkorb anschlagen, einem vorbestimmten Wert entspricht; dieser Abstand ist lediglich um die Dicke der Frontplatten verringert.

Bevorzugt wird der vorbestimmte Wert derart gewählt, dass sich die Steckkarten, die auf die zweite Backplane gesteckt werden, vollständig im hinteren Kartenkorb befinden und die Frontplatten der Steckkarten mit dem hinteren Kartenkorb bündig abschließen. Dies wird erreicht, indem der Abstand zwischen der Vorderseite der zweiten Backplane und der Rückseite des Gehäuses ausreichend groß dimensioniert wird. Die Rückseite des Gehäuses wird von den Teil-Frontplatten der Steckbaugruppen gebildet, deren Steckkarten auf die zweite Backplane aufgesteckt werden. Es ist gleichbedeutend, anstelle des vorstehend definierten Abstands den Abstand zwischen der Vorderseite der zweiten Backplane und einer Anschlagfläche, an der die Fronplatten am hinteren Kartenkorb anschlagen, ausreichend groß zu dimensionieren.

Beispielsweise werden vor dem Einbau der Backplanes in das Gehäuse die Dicke der Backplanes und die Länge der Abstandshalter gemessen. Basierend auf diesen Messungen wird die Gesamttoleranz dieser Bauteile ermittelt. In Abhängigkeit von der Position der Befestigungspunkte im Gehäuse, an denen die erste Backplane befestigt wird, können dann die Tiefen der einzubringenden Plansenkungen berechnet werden. Somit ist es möglich, die Vorderseite der zweiten Backplane mit sehr geringen Toleranzen im Gehäuse zu positionieren. Das Einhalten eines vorbestimmten Abstands zwischen der Vorderseite der zweiten Backplane und der Front des Gehäuses kann somit gewährleistet werden. Gleichzeitig ist ein ausreichender Abstand zwischen der Vorderseite der zweiten Backplane und der Rückseite des Gehäuses gegeben.

Alternativ können die Plansenkungen unabhängig von der Ist-Dicke der Backplanes derart tief eingesenkt werden, dass eine vorbestimmte Restdicke der Backplanes bestehen bleibt. Die Restdicke wurde vorher in Abhängigkeit von den Abmessungen des Gehäuses und der Position der Befestigungspunkte zur Befestigung der ersten Backplane im Gehäuse gewählt. Diese Abmessungen unterliegen einer relativ geringen Toleranz, so dass die berechnete Restdicke in der Regel für weitere Gehäuse des gleichen Typs verwendet werden kann. Auch die gewählte Restdicke gewährleistet, dass der maximale Abstand zwischen der Vorderseite der zweiten Backplane und der Front des Gehäuses eingehalten wird.

Vorzugsweise weisen beide Backplanes an ihren einander zugewandten Rückseiten Plansenkungen auf. Dadurch ist es möglich, eine größere Gesamttoleranz mithilfe der Plansenkungen auszugleichen. Bei gleichbleibender Gesamttoleranz können die Tiefen der Plansenkungen reduziert werden. Die Schwächung der Stabilität der Backplanes durch die Plansenkungen wird dadurch minimiert.

In einer bevorzugten Ausführungsform weist jeder Abstandshalter einen Verbindungsabschnitt mit zwei einander gegenüberliegenden kreisförmigen Anlageflächen zur Anlage an den zugewandten Rückseiten der Backplanes auf. Mithilfe des Verbindungsabschnitts ist ein Verbinden der beiden parallel zueinander angeordneten Backplanes möglich. Bevorzugt sind die Innendurchmesser der Plansenkungen größer gewählt als die Abmessungen der Abstandshalter im Bereich der Anlageflächen. Sind die Abstandshalter zylindrisch ausgebildet, so sind die Außendurchmesser der Abstandshalter zweckmäßig kleiner als die Innendurchmesser der Plansenkungen. Somit ist gewährleistet, dass die Anlageflächen ungehindert auf dem Grund der Plansenkungen zur Anlage kommen; ein Verkanten der Abstandshalter beim Einführen in die Plansenkungen wird vermieden. Durch die definierten Anlageflächen ist eine exakte rechtwinklige Ausrichtung der Abstandshalter relativ zu den Backplanes gewährleistet.

Optional sind beide Backplanes durch die Abstandshalter elektrisch miteinander verbunden. Es versteht sich, dass die Abstandshalter in diesem Fall aus elektrisch leitfähigem Material, vorzugsweise Metall, bestehen. Wird beispielsweise die erste Backplane über ein Netzgerät mit einer Versorgungspannung versorgt, so kann diese über die elektrische Verbindung zwischen den beiden Backplanes an die zweite Backplane weitergegeben werden. Zusätzliche Kabel oder Verbindungsstecker an der zweiten Backplane sind nicht notwendig.

Es ist vorteilhaft, wenn beide Backplanes Durchgangsbohrungen aufweisen, die konzentrisch zu den Plansenkungen angeordnet sind. Dadurch können die beiden Backplanes durch die Abstandshalter mechanisch miteinander verbunden werden. Die zweite Backplane kann so sicher auf der ersten Backplane befestigt werden.

Bevorzugt sind zumindest auf den beiden Vorderseiten der Backplanes elektrisch leitende kreisförmige Kontaktflächen (Augen) konzentrisch zu den Durchgangsbohrungen angeordnet. Die elektrische Verbindung der beiden Backplanes erfolgt dann mithilfe von metallenen Unterlegscheiben, die auf den Kontaktflächen zur Anlage kommen. Die Abstandshalter werden mit den Unterlegscheiben in Kontakt gebracht, wodurch die beiden Backplanes elektrisch miteinander verbunden sind. Es ist aber ebenso gut möglich, die Durchgangsbohrungen mit einer Durchkontaktierung auszubilden.

Ein weiteres optionales Merkmal der Erfindung ist, dass die Abstandshalter als Abstandsbolzen ausgebildet sind, die jeweils zwei beidseitig auf den Verbindungsabschnitt folgende Gewindeabschnitte mit einem gegenüber dem Verbindungsabschnitt reduzierten Durchmesser aufweisen. Die Abstandsbolzen können als Drehteile ausgeführt sein, was eine kostengünstige Fertigung dieser Bauteile ermöglicht. Um die Backplanes mithilfe der Abstandsbolzen miteinander elektrisch zu verbinden, können die Abstandsbolzen optional aus elektrisch leitfähigem Material hergestellt sein. Aufgrund der abgestuften Durchmesser befindet sich an Übergängen von einem Verbindungsabschnitt zu den Gewindeabschnitten hin jeweils ein Absatz, an dem die Anlageflächen ausgebildet sind. Optional weisen die Gewindeabschnitte Außengewinde auf. Es ist aber auch denkbar, Innengewinde vorzusehen.

In einer besonders bevorzugten Ausführungsform ragen die zwei Gewindeabschnitte eines Abstandshalters von den Rückseiten beider Backplanes aus durch die Durchgangsbohrungen hindurch. Die Gewindeabschnitte können über die Vorderseite beider Backplanes hinausragen. Unterlegscheiben und Muttern können auf die Außengewinde der Gewindeabschnitte aufgeschoben bzw. aufgeschraubt und so die Backplanes zwischen dem Verbindungsabschnitt und der jeweiligen Mutter eingespannt werden. Beispielsweise sind die Durchmesser der Gewindeabschnitte derart gewählt, dass sie mit den Unterlegscheiben in Berührung kommen. Im Falle von durchkontaktierten Durchgangsbohrungen könnten die Durchmesser der Gewindeabschnitte derart gewählt sein, dass sie mit der Innenwandung der durchkontaktierten Durchgangsbohrungen in Berührung kommen. Eine elektrische Verbindung zwischen den beiden Backplanes wäre somit ebenfalls gewährleistet.

Es ist aber auch denkbar, dass die Gewindeabschnitte bündig oder annähernd bündig mit den Vorderseiten der Backplanes abschließen. Die Gewindeabschnitte weisen dann Innengewinde auf, in die beispielsweise Schrauben von der Vorderseite der Backplanes aus eingeschraubt werden. Beide alternative Befestigungsarten ermöglichen ein sicheres Verbinden der Backplanes mithilfe der Abstandshalter.

In einer weiteren Ausführungsform weisen die Abstandshalter an ihren Anlageflächen Innengewinde auf. Bevorzugt sind die Abstandshalter als Zylinder ausgebildet, an deren Längsenden sich die Anlageflächen zur Anlage an den Rückseiten der beiden Backplanes befinden.

Es ist zweckmäßig, dass Befestigungsmittel vorgesehen sind, die von den Vorderseiten der Backplanes aus durch die Durchgangsbohrungen hindurchragen und in die Innengewinde der Abstandshalter eingreifen. Die Befestigungsmittel sind bevorzugt als Schrauben ausgeführt, die entweder direkt oder über Unterlegscheiben an den elektrisch leitenden Flächen zur Anlage kommen. Eine elektrische Verbindung der beiden Backplanes wird dann über die Unterlegscheiben, die Schrauben und den Abstandshalter ermöglicht, in den die Schrauben eingeschraubt sind.

Optional sind die Abstandshalter als Hülsen ausgebildet, durch die jeweils eine Gewindestange hindurchragt. Sowohl Gewindestangen wie Abstandshalter sind als Kaufteile erhältlich, wodurch keine zusätzlichen Arbeitsschritte zur Bearbeitung der Hülsen und/oder der Gewindestangen notwendig sind. Hülsen und Gewindestangen stellen damit eine besonders kostengünstige Möglichkeit zur Realisierung der Abstandshalter dar.

Bevorzugt ragen die Gewindestangen beidseitig von den Rückseiten der Backplane aus durch die Durchgangsbohrungen hindurch. Beispielsweise werden die Gewindestangen durch die Hülsen hindurch geführt und anschließend in die Durchgangsbohrungen der Backplanes eingeführt. Ein Befestigen der Gewindestangen an den beiden Backplanes erfolgt dann mithilfe von Muttern, die auf die Gewindestangen aufgeschraubt werden, so dass die Backplanes zwischen der Hülse und der jeweiligen Mutter eingespannt sind.

Ein Ausführungsbeispiel der Erfindung wird nachstehend anhand der beigefügten Zeichnungen beschrieben. Es zeigen:
- Figur 1: ein Gehäuse mit zwei parallelen Backplanes, die über Abstandshalter miteinander verbunden sind, in einem Vertikalschnitt;
- Figur 2: eine Detailansicht A eines Abstandshalters aus Figur 1.

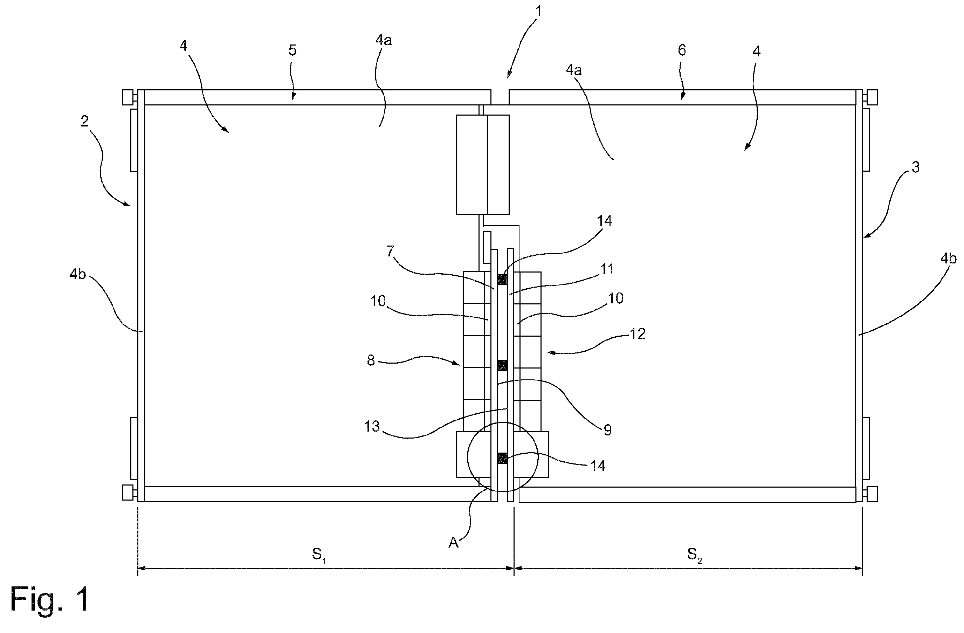

Figur 1 zeigt ein Gehäuse 1 mit einer Front 2 und einer Rückseite 3. Das Gehäuse 1 dient zur Aufnahme von elektronischen Steckbaugruppen 4 umfassend Steckkarten 4a und Frontplatten 4b. Die Frontplatten 4b werden mit dem Gehäuses 1 verbunden, so dass die Frontplatten 4b die Vorderseite 2 und die Rückseite 3 des Gehäuses 1 bilden.

Das Gehäuse 1 umfasst einen vorderen Kartenkorb 5 zum Einbau von Steckkarten 4a von der Front 2 her und einen hinteren Kartenkorb 6 zum Einbau von Steckkarten 4a von der Rückseite 3 her.

Am Ende des vorderen Kartenkorbs 5 ist eine erste Backplane 7 mit einer Vorderseite 8 und einer Rückseite 9 angeordnet. Die erste Backplane 7 weist an der Vorderseite 8 Stecker 10 zum Einstecken der Steckkarten 4a im vorderen Kartenkorb 5 auf. Die erste Backplane 7 ist im Gehäuse 1 derart vertikal befestigt, dass ihre Vorderseite 8 zur Front 2 des Gehäuses 1 hin weist.

Eine zweite Backplane 11 ist parallel zur ersten Backplane 7 und von dieser beabstandet auf der Rückseite 9 der ersten Backplane 7 angeordnet. Die zweite Backplane 11 verfügt ebenfalls über eine Vorderseite 12 und eine Rückseite 13. An der Vorderseite 12 der zweiten Backplane 11 sind weitere Stecker 10 angeordnet, in welche die im hinteren Kartenkorb 6 befindlichen Steckkarten 4a eingesteckt werden können. Die zweite Backplane 11 ist im Gehäuse 1 derart angeordnet, dass ihre Vorderseite 12 zur Rückseite 3 des Gehäuses 1 weist.

Die Vorderseite 12 der zweiten Backplane 11 ist in einem Abstand s₁ von der Front 2 des Gehäuses 1 angeordnet. Die Größe des Abstands s₁ ist von einem Abstand s₂ abhängig, der sich zwischen der Vorderseite 12 der zweiten Backplane 11 und der Rückseite 3 des Gehäuses 1 erstreckt. Der Abstand s₂ ist derart gewählt, dass Steckkarten 4a von der Rückseite 3 des Gehäuses 1 her in die Stecker 10 der zweiten Backplane 11 eingesteckt werden können und sich vollständig im Raum des hinteren Kartenkorbs 6 befinden. Die Steckkarten 4a ragen nicht aus dem hinteren Kartenkorb 6 heraus, so dass die Frontplatten 4b bündig mit dem hinteren Kartenkorb 6 abschließen.

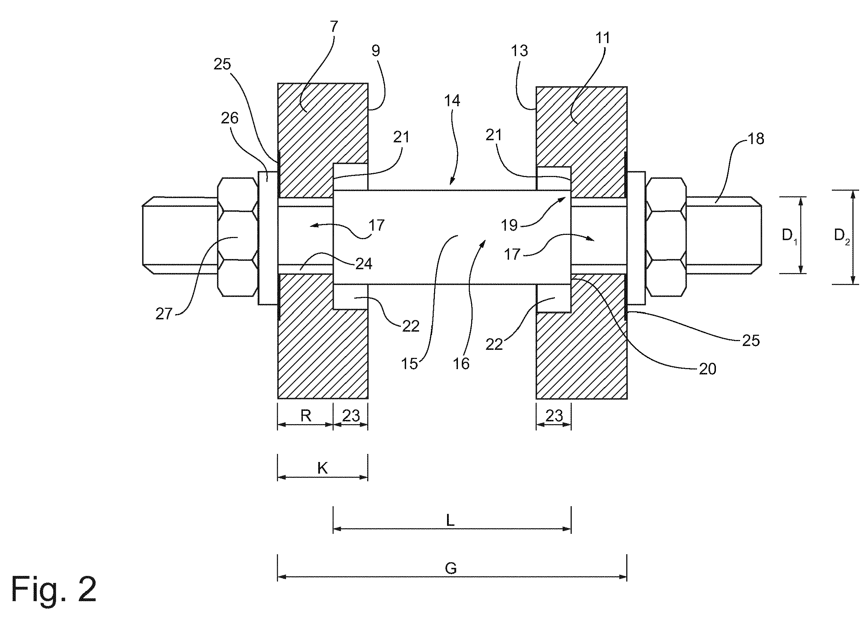

Das Gehäuse 1 umfasst weiter Abstandshalter 14, welche die beiden Backplanes 7, 11 sowohl mechanisch wie auch elektrisch miteinander verbinden. Figur 2 zeigt einen solchen Abstandshalter 14 im Detail (Bereich A aus Figur 1).

Der Abstandshalter 14 ist als Abstandsbolzen 15 ausgebildet. Er weist einen Verbindungsabschnitt 16 und zwei beidseitig auf den Verbindungsabschnitt 16 folgende Gewindeabschnitte 17 mit Außengewinden 18 auf. Der Durchmesser D₁ der Gewindeabschnitte 17 ist kleiner ausgebildet als der Durchmesser D₂ des Verbindungsabschnitts 16. An den Übergängen von dem Verbindungsabschnitt 16 zu den Gewindeabschnitten 17 sind Absätze 19 angeordnet, an denen sich einander gegenüberliegende kreisförmige Anlageflächen 20 befinden.

Die Anlageflächen 20 kommen jeweils an einem Grund 21 von Plansenkungen 22 zur Anlage. Die Plansenkungen 22 sind an den einander zugewandten Rückseiten 9, 13 der beiden Backplanes 7, 11 angeordnet und weisen eine Tiefe 23 auf. Die Tiefen 23 der Plansenkungen 22 sind derart gewählt, dass der Abstand s₁ (Figur 1) zwischen der Vorderseite 12 der zweiten Backplane 11 und der Front 2 des Gehäuses 1 einem vorbestimmten Wert entspricht. Der vorbestimmte Wert ist derart gewählt, dass sich die Steckkarten 4a, die auf die zweite Backplane 11 gesteckt werden, sicher im Inneren des hinteren Kartenkorbs 6 befinden und nicht etwa aus diesem herausragen. Dies bedeutet, dass der Abstand s₂ (Figur 1) zwischen der Vorderseite 12 der zweiten Backplane 11 und der Rückseite 3 des Gehäuses 1 ausreichend groß sein muss.

Es ist aber auch denkbar, dass nur eine der beiden Backplanes 7, 11 Plansenkungen 22 aufweist. In diesem Fall käme nur eine der beiden Anlageflächen 20 an dem Grund 21 einer Plansenkung 22 zur Anlage. Die Tiefe dieser Plansenkung 22 ist dann entsprechend so zu wählen, dass der Abstand s₁ (Figur 1) einem vorbestimmten Wert entspricht. Die gegenüberliegende Anlagefläche 20 des Abstandshalters 14 käme an einer gegenüberliegenden Rückseite 9, 13 einer der beiden Backplanes 7, 11 zur Anlage.

Konzentrisch zu den Plansenkungen 22 sind Durchgangsbohrungen 24 in den beiden Backplanes 7, 11 vorgesehen. Auf den Vorderseiten 8, 12 der beiden Backplanes 7, 11 sind elektrisch leitende Kontaktflächen (Augen) 25 konzentrisch zu den Durchgangsbohrungen 24 angeordnet.

Die Gewindeabschnitte 17 des Abstandsbolzens 15 ragen von den Rückseiten 9, 13 der beiden Backplanes 7, 11 aus durch die Durchgangsbohrungen 24 hindurch. Von den Vorderseiten 8, 12 der beiden Backplanes 7, 11 aus werden Unterlegscheiben 26 und Muttern 27 auf die Gewindeabschnitte 17 aufgesteckt bzw. aufgeschraubt. Die Unterlegscheiben 26 liegen an den Kontaktflächen 25 an und berühren gleichzeitig die Gewindeabschnitte 17. Durch Anziehen der Mutter 27 werden die beiden Backplanes 7, 11 zwischen dem Abstandsbolzen 15 und der jeweiligen Mutter 27 eingespannt.

Die elektrische Verbindung der beiden Backplanes 7, 11 erfolgt dadurch, dass die Gewindeabschnitte 17 und damit die Abstandshalter 14 über die Unterlegscheiben 26 mit den Kontaktflächen 25 in Berührung kommen. Es versteht sich, dass die Abstandshalter 14 aus elektrisch leitfähigem Material, vorzugsweise Metall, bestehen.

Es ist auch denkbar, dass die Abstandshalter 14 an ihren Anlageflächen 20 Innengewinde aufweisen. Ein Verbinden der beiden Backplanes 7, 11 mithilfe der Abstandshalter 14 erfolgt dann mithilfe von Schrauben, die von den Vorderseiten 8, 12 der Backplanes 7, 11 aus durch die Durchgangsbohrungen 24 hindurch in die Innengewinde der Abstandshalter 14 greifen.

Alternativ können die Abstandshalter 14 auch als Hülsen ausgebildet sein, durch die jeweils eine Gewindestange hindurchragt. Im montierten Zustand ragen die Gewindestangen von den einander zugewandten Rückseiten 9, 13 der beiden Backplanes 7, 11 aus durch die Durchgangsbohrungen 24. Auf den Vorderseiten 8, 12 der beiden Backplanes 7, 11 werden Unterlegscheiben 26 und Muttern 27 auf die Gewindestange aufgesteckt bzw. aufgeschraubt, so dass die Backplanes 7, 11 zwischen der Hülse und der jeweiligen Mutter 27 eingespannt sind.

Im Folgenden soll die Vorbereitung der Backplanes 7, 11 zum Einbau in das Gehäuse 1 und der anschließende Einbau anhand der Figuren 1 und 2 beschrieben werden.

Damit in die zweite Backplane 11 eingesteckte Steckkarten 4a nicht aus dem Gehäuse 1 herausragen bzw. damit die Frontplatten 4b bündig mit dem hinteren Kartenkorb 6 abschließen, muss ein ausreichender Abstand s₂ zwischen der Vorderseite 12 der zweiten Backplane 11 und der Rückseite 3 des Gehäuses 1 vorhanden sein. Dies bedingt, dass die Vorderseite 12 der zweiten Backplane 11 in einem bestimmten Abstand s₁ zur Vorderseite 2 des Gehäuses 1 positioniert ist. Der Abstand s₁ muss also einem vorbestimmten Wert entsprechen, um den korrekten Sitz der Steckkarten 4a in dem hinteren Kartenkorb 6 zu gewährleisten. Dieser Wert ist in Abhängigkeit von den Abmessungen des Gehäuses 1, der Backplanes 7, 11, der Steckkarten 4a und den Frontplatten 4b zu berechnen.

Die Position von Befestigungspunkten zur Befestigung der ersten Backplane 7 im Gehäuse 1 ist bekannt; sie unterliegt nur geringen Fertigungstoleranzen. Viel höheren Herstellungstoleranzen unterliegt dagegen die Dicke K der Backplanes 7, 11. Diese Toleranz liegt bei ± 10 % der Solldicke der Backplanes 7, 11. Da die zweite Backplane 11 mithilfe von Abstandshaltern 14 auf die erste Backplane 7 montiert wird, würden sich ohne vorbereitende Bearbeitungsschritte an den Backplanes 7, 11 die Toleranzen hinsichtlich der Dicken K der Backplanes 7, 11 aufaddieren. Dadurch würde der Abstand s₁ herstellungsbedingt zu stark schwanken.

Um diese fertigungstechnisch bedingten Schwankung auszugleichen oder zu minimieren, werden an den Rückseiten 9, 13 der beiden Backplanes 7, 11 Plansenkungen 22 mit den Tiefen 23 eingearbeitet. Dabei werden die Tiefen 23 der Plansenkungen 22 derart gewählt, dass der Abstand s₁ zwischen der Vorderseite 12 der zweiten Backplane 11 und der Front 2 des Gehäuses 1 dem berechneten vorbestimmten Wert entspricht. Dies kann auf unterschiedliche Art und Weise erfolgen:
Zum einen können die Tiefen 23 der Plansenkungen 22 für jedes Gehäuse 1 individuell in Abhängigkeit von den Abmessungen des Gehäuses 1, der Backplanes 7, 11, der Steckkarten 4a und der Frontplatten 4b berechnet werden. Dies ist mit einem erhöhten Arbeitsaufwand verbunden.

Zum anderen ist es denkbar, die Plansenkungen 22 immer so weit in die Backplanes 7, 11 einzusenken, dass eine definierte Restdicke R der Backplanes 7, 11 bestehen bleibt. Die Restdicke R kann dadurch mit einer Toleranz von ± 0,1 mm eingehalten werden. Somit ist es möglich, eine Gesamtlänge G, bestehend aus den Restdicken R der Backplanes 7, 11 und einer Länge L des Abstandshalters 14, mit sehr geringen Toleranzen, dass heißt mit Toleranzen nahe 0 mm, zu gewährleisten. Dadurch kann die zweite Backplane 11 im Gehäuse 1 derart positioniert werden, dass der Abstand s₁ sehr genau einem vorbestimmten Wert entspricht. Die Restdicke der Backplanes wurde vorher in Abhängigkeit von den Abmessungen eines Gehäuses, der Position der Befestigungspunkte für die erste Backplane und den Abmessungen einer Steckbaugruppe einmalig festgelegt. Da die Abmessungen des Gehäuses nur einer geringen Herstellungstoleranz unterliegen, kann die einmalig definierte Restdicke R für eine Vielzahl von Gehäusen des gleichen Typs verwendet werden.

Im Vergleich zur ersten Möglichkeit, das heißt der individuellen Bestimmung der Tiefen 23, ist die zweite Möglichkeit kostengünstiger und daher auch zu bevorzugen. Dies deshalb, weil der technische Aufwand beim Planeinsenken bis zu einer Restdicke R der Backplanes 7, 11 geringer ist.

Der Einbau der beiden Backplanes 7, 11 im Gehäuse 1 erfolgt dann, indem zuerst die erste Backplane 7 im Gehäuse 1 befestigt wird. Nachdem die Abstandshalter 14 mit der ersten Backplane 7 verschraubt sind und damit die Anlageflächen 20 der Abstandshalter 14 auf dem Grund 21 der Plansenkungen 22 der ersten Backplane 7 anliegen, erfolgt das Aufstecken und Befestigen der zweiten Backplane 11 an den freien Enden der Abstandshalter 14. Dabei kommen die gegenüberliegenden Anlageflächen 20 des Abstandshalters 14 auf dem Grund 21 der Plansenkungen 22 der zweiten Backplane 11 zur Anlage. Nun können die Steckkarten 4a der Steckbaugruppen 4 in die Stecker 10 der beiden Backplanes 7, 11 eingesteckt werden, ohne dass die Gefahr bestünde, sie würden nicht in den Raum des hinteren Kartenkorbs 6 passen. Die Frontplatten 4b der Steckbaugruppen 4 schließen bündig mit dem hinteren Kartenkorb 6 ab und werden mit dem Gehäuse beispielsweise mittels Schraubverbindungen verbunden.

### Bezugszeichen

- 1: Gehäuse
- 2: Front (Gehäuse)
- 3: Rückseite (Gehäuse)
- 4: Steckbaugruppe
- 4a: Steckkarte
- 4b: Frontplatte
- 5: vorderer Kartenkorb
- 6: hinterer Kartenkorb
- 7: erste Backplane
- 8: Vorderseite (erste Backplane)
- 9: Rückseite (erste Backplane)
- 10: Stecker
- 11: zweite Backplane
- 12: Vorderseite (zweite Backplane)
- 13: Rückseite (zweite Backplane)
- s₁: Abstand
- s₂: Abstand
- 14: Abstandshalter
- 15: Abstandsbolzen
- 16: Verbindungsabschnitt
- 17: Gewindeabschnitt
- 18: Außengewinde
- D₁: Durchmesser (Gewindeabschnitt)
- D₂: Durchmesser (Verbindungsabschnitt)
- 19: Absätze
- 20: Anlagefläche
- 21: Grund (Plansenkung)
- 22: Plansenkung
- 23: Tiefe
- 24: Durchgangsbohrung
- 25: Kontaktfläche
- 26: Unterlegscheibe
- 27: Mutter
- K: Dicke (Backplane)
- R: Restdicke (Backplane)
- G: Gesamtlänge
- L: Länge (Abstandshalter)

## Patentansprüche

1. Gehäuse zur Aufnahme von elektronischen Steckkarten (4a), mit
einer Front (2),
einer Rückseite (3),
einem vorderen Kartenkorb (5) zum Einbau von Steckkarten (4a) von der Front (2) her,
einem hinteren Kartenkorb (6) zum Einbau von Steckkarten (4a) von der Rückseite (3) her,
einer ersten vertikalen Backplane (7) mit einer Vorderseite (8) und einer Rückseite (9), wobei die erste Backplane (7) am Ende des vorderen Kartenkorbs (5) an Befestigungspunkten so befestigt ist, dass ihre Vorderseite (8) zur Front (2) des Gehäuses (1) weist,
einer zweiten vertikalen Backplane (11) mit einer Vorderseite (12) und einer Rückseite (13), wobei die zweite Backplane (11) parallel und mit Abstand auf der Rückseite (9) der ersten Backplane (7) so angeordnet ist, dass die Vorderseite (12) der zweiten Backplane (11) zur Rückseite (3) des Gehäuses (1) weist, und
Abstandshaltern (14), welche die beiden Backplanes (7, 11) miteinander verbinden,
**dadurch gekennzeichnet, dass**
mindestens eine der einander zugewandten Rückseiten (9, 13) der beiden parallelen Backplanes (7, 11) Plansenkungen (22) aufweist, an deren Grund (21) die Abstandshalter (14) anliegen, und
die Tiefen (23) der Plansenkungen (22) in Abhängigkeit der Dicke der Backplanes (7, 11), der Länge der Abstandshalter (14) und der Position der Befestigungspunkte der ersten Backplane (7) im Gehäuse (1) bzw.
die Restdicken der Backplanes (7, 11) nach Einbringen der Plansenkungen (22) in Abhängigkeit von der Abmessungen des Gehäuses (1) und der Position der Befestigungspunkte der ersten Backplane (7) im Gehäuse (1) derart gewählt sind, dass der Abstand (s₁) zwischen der Vorderseite (12) der zweiten Backplane (11) und der Front (2) des Gehäuses (1) einem vorbestimmten Wert entspricht, der derart gewählt ist, dass sich die Steckkarten (4a), die auf die zweite Backplane (11) gesteckt werden, vollständig im hinteren Kartenkorb (6) befinden und die Frontplatte der Steckkarten (4a) mit dem hinteren Kartenkorb (6) bündig abschließen.

2. Gehäuse nach Anspruch 1, **dadurch gekennzeichnet, dass** beide Backplanes (7, 11) an ihren einander zugewandten Rückseiten (9, 13) Plansenkungen (22) aufweisen.

3. Gehäuse nach einem der vorhergehenden Ansprüche, **dadurch gekennzeichnet, dass** jeder Abstandshalter (14) einen Verbindungsabschnitt (16) mit zwei einander gegenüberliegenden kreisförmigen Anlageflächen (20) zur Anlage an den zugewandten Rückseiten (9, 13) der Backplanes (7, 11) aufweist.

4. Gehäuse nach einem der vorhergehenden Ansprüche, **dadurch gekennzeichnet, dass** die beiden Backplanes (7, 11) durch die Abstandshalter (14) elektrisch miteinander verbunden sind.

5. Gehäuse nach einem der vorhergehenden Ansprüche, **dadurch gekennzeichnet, dass** die beiden Backplanes (7, 11) Durchgangsbohrungen (24) aufweisen, die konzentrisch zu den Plansenkungen (22) angeordnet sind.

6. Gehäuse nach einem der vorhergehenden Ansprüche, **dadurch gekennzeichnet, dass** die Abstandshalter (14) als Abstandsbolzen (15) ausgebildet sind, die jeweils zwei beidseitig auf den Verbindungsabschnitt (16) folgende Gewindeabschnitte (17) mit einem gegenüber dem Verbindungsabschnitt (16) reduziertem Durchmesser (D₁) aufweisen.

7. Gehäuse nach den Ansprüchen 5 und 6 **dadurch gekennzeichnet, dass** die zwei Gewindeabschnitte (17) eines Abstandshalters (14) von den Rückseiten (9, 13) beider Backplanes (7, 11) aus durch die Durchgangsbohrungen (24) hindurchragen.

8. Gehäuse nach Anspruch 3, **dadurch gekennzeichnet, dass** die Abstandshalter (14) an ihren Anlageflächen (20) Innengewinde aufweisen.

9. Gehäuse nach den Ansprüchen 5 und 8, **dadurch gekennzeichnet**, das Befestigungsmittel vorgesehen sind, die von den Vorderseiten (8, 12) der Backplanes (7, 11) aus durch die Durchgangsbohrungen (24) hindurchragen und in die Innengewinde der Abstandshalter (14) eingreifen.

10. Gehäuse nach einem der Ansprüche 1 bis 5, **dadurch gekennzeichnet, dass** die Abstandshalter (14) als Hülsen ausgebildet sind, durch die jeweils eine Gewindestange hindurchragt.

11. Gehäuse nach den Ansprüchen 5 und 10, **dadurch gekennzeichnet, dass** die Gewindestange beidseitig von den Rückseiten (9, 13) der Backplanes (7, 11) aus durch die Durchgangsbohrungen (24) hindurchragen.

## Claims

1. Cabinet for housing electronic plug-in cards (4a), comprising
a front (2),
a back (3),
a front card basket (5) for inserting plug-in cards (4a) from the front (2),
a rear card basket (6) for inserting plug-in cards (4a) from the back (3),
a first vertical backplane (7) having a front side (8) and a rear side (9), wherein the first backplane (7) is attached to the end of the front card basket (5) at attachment points such that the front side (8) of said backplane (7) points to the front (2) of the cabinet (1),
a second vertical backplane (11) having a front side (12) and a rear side (13). wherein the second backplane (11) is arranged in parallel and at a distance on the rear side (9) of the first backplane (7) in such a way that the front side (12) of said second backplane (11) points to the back (3) of the cabinet (1), and
distance pieces (14), which connect the two backplanes (7, 11) with each other,
**characterized in that**
at least one of the facing rear sides (9, 13) of the two parallel backplanes (7, 11) is provided with counterbores (22), the bottom (21) of which is contacted by the distance pieces (14), and
the depths (23) of the counterbores (22) are chosen in dependence of the thickness of the backplanes (7, 11), the length of the distance pieces (14) and the position of the attachment points of the first backplane (7) in the cabinet (1), or the residual thicknesses of the backplanes (7, 11) after drilling the counterbores (22) are chosen in dependence of the dimensions of the cabinet (1) and the position of the attachment points of the first backplane (7) in the cabinet (1) such that the distance (s₁) between the front side (12) of the second backplane (11) and the front (2) of the cabinet (1) corresponds to a pre-determined value, which is chosen such that the plug-in cards (4a), which are pushed onto the second backplane (11), are completely received inside the rear card basket (6), and the front plate of the plug-in cards (4a) ends flush with the rear card basket (6).

2. Cabinet according to claim 1, **characterized in that** both backplanes (7, 11) comprise counterbores (22) on their facing rear sides (9, 13).

3. Cabinet according to any one of the preceding claims, **characterized in that** each distance piece (14) comprises a connecting portion (16) with two circular contact surfaces (20) lying opposite each other for making contact with the facing rear sides (9, 13) of the backplanes (7, 11).

4. Cabinet according to any one of the preceding claims, **characterized in that** the two backplanes (7, 11) are electrically connected with each other via the distance pieces (14).

5. Cabinet according to any one of the preceding claims, **characterized in that** the two backplanes (7, 11) comprise through-holes (24), which are arranged concentrically to the counterbores (22).

6. Cabinet according to any one of the preceding claims, **characterized in that** the distance pieces (14) are configured as distance bolts (15), each of which comprises two threaded portions (17) following on from the connecting portion (16) on either side and a diameter (D₁) that is reduced relative to the connecting portion (16).

7. Cabinet according to claims 5 and 6, **characterized in that** the two threaded portions (17) of a distance piece (14) extend starting from the rear sides (9, 13) of the two backplanes (7, 11) through the through-holes (24).

8. Cabinet according to claim 3, **characterized in that** the distance pieces (14) comprise internal threads at their contact surfaces (20).

9. Cabinet according to claims 5 and 8, **characterized in that** fastening means are provided, which extend starting from the front sides (8, 12) of the backplanes (7, 11) through the through-holes (24) and engage in the internal threads of the distance pieces (14).

10. Cabinet according to any one of the claims 1 to 5, **characterized in that** the distance pieces (14) are configured as sleeves, through each of which a threaded rod extends.

11. Cabinet according to claims 5 and 10, **characterized in that** the threaded rod extends on either side starting from the rear sides (9, 13) of the backplanes (7, 11) through the through holes (24).

## Revendications

1. Boîtier destiné à la réception de cartes électroniques enfichables (4a) comportant :
une face frontale (2) ;
une face arrière (3) ;
un réceptacle avant pour carte (5) pour la pose de cartes enfichables (4a) depuis la face frontale (2) ;
un réceptacle arrière pour carte (6) pour la pose de cartes enfichables (4a) depuis la face arrière (3) ;
un premier fond de réceptacle vertical (7) avec une face avant (8) et une face arrière (9), le premier fond de réceptacle (7) étant fixé à l'extrémité du réceptacle avant pour carte (5) à des points de fixations de manière telle que sa face avant (8) est tournée vers la face frontale (2) du boîtier (1) ;
un deuxième fond de réceptacle vertical (11) avec une face avant (12) et
une face arrière (13), le deuxième fond de réceptacle (11) étant agencé parallèlement et à distance sur la face arrière (9) du premier fond de réceptacle (7) de manière telle que la face avant (12) du deuxième fond de réceptacle (11) est tournée vers la face arrière (3) du boîtier (1) ; et
des espaceurs (14) qui relient les deux fonds de réceptacle (7, 11) entre eux,
**caractérisé en ce que**
au moins l'une des faces arrière mutuellement en regard (9, 13) des deux fonds de réceptacle parallèles (7, 11) comporte des lamages (22) au fond (21) desquels les espaceurs (14) sont appliqués et
les creux (23) des lamages (22) sont choisis de manière telle en fonction de l'épaisseur des fonds de réceptacle (7, 11), de la longueur des espaceurs (14) et de la position des points de fixation du premier fond de réceptacle (7) dans le boîtier (1) resp. les épaisseurs résiduelles des fonds de réceptacle (7, 11) après réalisation des lamages (22) sont choisies de manière telle en fonction des dimensions du boîtier (1) et de la position des points de fixation du premier fond de réceptacle (7) dans le boîtier (1) que la distance (s₁) entre la face avant (12) du deuxième fond de réceptacle (11) et la face frontale (2) du boîtier (1) correspond à une valeur prédéfinie qui est choisie de telle sorte que les cartes enfichables (4a) qui sont enfichées sur le deuxième fond de réceptacle (11) se trouvent entièrement dans le réceptacle arrière pour carte (6) et que la plaque frontale des cartes enfichables (4a) et le réceptacle arrière pour carte (6) sont en affleurement.

2. Boîtier selon la revendication 1, **caractérisé en ce que** les deux fonds de réceptacle (7, 11) présentent des lamages (22) sur leurs faces arrière mutuellement en regard (9, 13).

3. Boîtier selon l'une des revendications précédentes, **caractérisé en ce que** chaque espaceur (14) comporte une section de liaison (16) avec deux surfaces d'appui circulaires en vis-à-vis (20) destinées à venir s'appliquer sur les faces arrières en regard (9, 13) des fonds de réceptacle (7, 11).

4. Boîtier selon l'une des revendications précédentes, **caractérisé en ce que** les deux fonds de réceptacle (7, 11) sont reliés électriquement entre eux par des espaceurs (14).

5. Boîtier selon l'une des revendications précédentes, **caractérisé en ce que** les deux fonds de réceptacle (7, 11) présentent des perçages traversants (24) agencés concentriquement par rapport aux lamages (22).

6. Boîtier selon l'une des revendications précédentes, **caractérisé en ce que** les espaceurs (14) se présentent sous la forme de boulons d'écartement (15) qui présentent respectivement deux sections filetées (17) faisant suite de part et d'autre à la section de liaison (16) et présentant un diamètre (D₁) réduit par rapport à la section de liaison (16).

7. Boîtier selon les revendications 5 et 6, **caractérisé en ce que** les deux sections filetées (17) d'un espaceur (14) ressortent des perçages traversants (24) sur les faces arrière (9, 13) des deux fonds de réceptacle (7, 11).

8. Boîtier selon la revendication 3, **caractérisé en ce que** les espaceurs (14) présentent des taraudages sur leurs surfaces de contact (20).

9. Boîtier selon les revendications 5 et 8, **caractérisé en ce que** sont prévus des moyens de fixation qui ressortent des perçages traversants (24) sur les faces avant (8, 12) des fonds de réceptacle (7,11) et s'engagent dans les taraudages des espaceurs (14).

10. Boîtier selon l'une des revendications 1 à 5, **caractérisé en ce que** les espaceurs (14) se présentent sous la forme de douilles dont ressort respectivement une tige filetée.

11. Boîtier selon les revendications 5 et 10, **caractérisé en ce que** la tige filetée ressort des deux côtés des perçages traversants (24) sur les faces arrière (9, 13) des fonds de réceptacle (7, 11).
